# EUROPÄISCHE PATENTSCHRIFT

(11) **EP 3 983 172 B1**
(45) Veröffentlichungstag und Bekanntmachung des Hinweises auf die Patenterteilung: **05.07.2023**
(21) Anmeldenummer: 20726413.6
(22) Anmeldetag: 15.05.2020
(51) Int. Cl.: B24B 37/08, B24B 37/34, B24B 51/00

(54) **EINRICHTUNG UND VERFAHREN ZUM POLIEREN VON HALBLEITERSCHEIBEN**
APPARATUS AND METHOD FOR POLISHING SEMICONDUCTOR WAFERS
DISPOSITIF ET PROCÉDÉ DE POLISSAGE DE PLAQUETTES DE SEMI-CONDUCTEURS

(30) Priorität: 14.06.2019 DE 102019208704
(43) Veröffentlichungstag der Anmeldung: 20.04.2022
(73) Patentinhaber: Siltronic AG, 81677 München (DE)
(72) Erfinder: FRANKE, Jonny, 09575 Eppendorf (DE); LAMPRECHT, Ludwig, 83376 Truchtlaching (DE)
(74) Vertreter: Staudacher, Wolfgang
(86) Internationale Anmeldenummer: PCT/EP2020/063685
(87) Internationale Veröffentlichungsnummer: WO 2020/249360

(56) Entgegenhaltungen:
- DE-A1- 10 228 441
- US-A- 5 679 055

## Beschreibung

Gegenstand der Erfindung ist eine Einrichtung zum Polieren von Halbleiterscheiben, die mindestens zwei Poliermaschinen zum gleichzeitigen beidseitigen Polieren von Halbleiterscheiben umfasst und einen hohen Grad an Automatisierung aufweist. Die Erfindung betrifft darüber hinaus auch ein Verfahren zum Polieren von Halbleiterscheiben, zu dessen Durchführung die Einrichtung eingesetzt wird.

### Stand der Technik / Probleme

Eine Poliermaschine zum gleichzeitigen beidseitigen Polieren von Halbleiterscheiben, in dieser Beschreibung auch DSP-Poliermaschine genannt, umfasst einen oberen und einen unteren Polierteller, die jeweils mit Poliertuch bedeckt sind. Die Halbleiterscheiben werden in Aussparungen von Läuferscheiben (carriers) liegend zwischen den Poliertellern in Gegenwart von Poliermittel (slurry) poliert.

Es gibt bereits Vorschläge, das Einlegen von zu polierenden Halbleiterscheiben in die Aussparungen der Läuferscheiben und das Herausnehmen von polierten Halbleiterscheiben aus den Aussparungen der Läuferscheiben zu automatisieren. In diesem Zusammenhang seien beispielsweise EP 0 931 623 A1, DE 100 07 389 A1 und DE 102 28 441 A1, JP 2005-243 996 A, JP 2005-294378 A, US 6 361 418 B1 und US 2017 0 323 814 A1 erwähnt.

US 5 679 055 A beschreibt ein automatisiertes System umfassend eine Maschine zum gleichzeitigen beidseitigen Läppen von Halbleiterscheiben, mit einer oder mehreren Läuferscheiben, die auf einem Poliertuch des unteren Poliertellers der Poliermaschine liegen und Aussparungen zur Aufnahme von Halbleiterscheiben aufweisen, sowie eine Kassette, die zu polierende Halbleiterscheiben enthält, aufweisend einen integrierten Scheibenheber zum Herausheben der zu polierenden Halbleiterscheiben aus der Kassette.

Ungeachtet dieser Vorschläge besteht weiterhin Bedarf an Verbesserungen, insbesondere an solchen, die kostenreduzierend und zeitsparend wirken.

Diese Aufgabe wird gelöst durch eine Einrichtung zum Polieren von Halbleiterscheiben, umfassend
mindestens zwei Poliermaschinen zum gleichzeitigen beidseitigen Polieren von Halbleiterscheiben;
eine oder mehrere Läuferscheiben, die auf einem Poliertuch eines jeweiligen unteren Poliertellers der Poliermaschinen liegen und Aussparungen zur Aufnahme von Halbleiterscheiben aufweisen;
ein deckenmontiertes Transportsystem zum Anliefern einer Kassette, die zu polierende Halbleiterscheiben enthält;
jeder der Poliermaschinen zugeordnet ein Vertikaltransportsystem zum Übernehmen der angelieferten Kassette vom deckenmontierten Transportsystem und aufweisend einen integrierten Scheibenheber zum Herausheben der zu polierenden Halbleiterscheiben aus der Kassette;
einen zu den mindestens zwei Poliermaschinen selbstständig fahrenden Roboter mit einem Manipulator zum Übernehmen der zu polierenden Halbleiterscheibe vom Scheibenheber, zum Einlegen der zu polierenden Halbleiterscheibe in eine der Aussparungen und, nach dem Abschluss einer Politur, zum Herausheben der polierten Halbleiterscheibe aus der Aussparung;
jeder der Poliermaschinen zugeordnet eine x/y-Lineareinheit mit einem Scheibengreifer zum Übernehmen der polierten Halbleiterscheibe vom Manipulator des selbstständig fahrenden Roboters und zum Ablegen der polierten Halbleiterscheibe in einen Nasstransportbehälter mit integrierter Scheibenaufnahme; und
ein fahrerloses Transportfahrzeug zum Transport des Nasstransportbehälters zu einer Reinigungsanlage für polierte Halbleiterscheiben.

Gegenstand der Erfindung ist des Weiteren ein Verfahren zum Polieren von Halbleiterscheiben, umfassend
das Bereitstellen von mindestens zwei Poliermaschinen zum gleichzeitigen beidseitigen Polieren von Halbleiterscheiben;
das Anliefern von zu polierenden Halbleiterscheiben in einer Kassette mittels eines deckenmontierten Transportsystems;
das Herausheben einer zu polierenden Halbleiterscheibe in zentriertem Zustand aus der Kassette mittels eines Scheibenhebers eines Vertikaltransportsystems;
das Übernehmen einer der zu polierenden Halbleiterscheiben vom Scheibenheber des deckenmontierten Transportsystems oder von einer Zentrierstation durch einen Manipulator eines selbstständig fahrenden Roboters;
das Einlegen der zu polierenden Halbleiterscheibe in eine Aussparung einer Läuferscheibe der mindestens zwei Poliermaschinen durch den Manipulator des selbstständig fahrenden Roboters;
das Entnehmen einer polierten Halbleiterscheibe aus einer der Aussparungen der Läuferscheiben mittels des Manipulators des selbstständig fahrenden Roboters;
das Übernehmen der polierten Halbleiterscheibe vom Manipulator des selbstständig fahrenden Roboters durch einen Scheibengreifer einer x/y-Lineareinheit;
das Ablegen der polierten Halbleiterscheibe in eine Scheibenaufnahme eines Nasstransportbehälters durch den Scheibengreifer;
das Umladen des Nasstransportbehälters von der x/y-Lineareinheit auf ein fahrerloses Transportfahrzeug; und
das Transportieren des Nasstransportbehälters mittels des fahrerlosen Transportfahrzeugs zu einer Reinigungsanlage für polierte Halbleiterscheiben.

Die Erfindung ermöglicht, den Prozess vom Anliefern zu polierender Halbleiterscheiben bis zum Transport der Halbleiterscheiben nach der Politur zu einer Reinigungsanlage vollautomatisch, platzsparend und kostensparend zu gestalten. Die Halbleiterscheiben sind vorzugsweise Halbleiterscheiben aus einkristallinem Silizium, besonders bevorzugt solche, die einen Durchmesser von mindestens 200 mm aufweisen.

Die Erfindung sieht unter anderem vor, mindestens zwei Poliermaschinen zum gleichzeitigen beidseitigen Polieren von Halbleiterscheiben durch einen selbstständig fahrenden Roboter mit Hableiterscheiben be- und entladen zu lassen. Vorzugsweise wird eine entsprechend der Dauer der Politur optimierte Anzahl an DSP-Poliermaschinen dem selbstständig fahrenden Roboter zugeordnet. Vorzugsweise werden mindestens 3 bis 10, besonders bevorzugt mindestens 3 bis 6 DSP-Poliermaschinen bereitgestellt, die vom selben selbstständig fahrenden Roboter angesteuert werden. Diese Lösung spart die Kosten ein, die entstünden, wenn für jede der Poliermaschinen ein eigener Roboter bereitgestellt würde. Dementsprechend ist auch der Platzbedarf geringer. Der selbstständig fahrende Roboter übernimmt zu polierende Halbleiterscheiben von einem Scheibenheber (wafer lift out) eines Vertikaltransportsystems oder von einer Zentrierstation. Jeder der DSP-Poliermaschinen ist ein solches Vertikaltransportsystem zugeordnet. Zu polierende Halbleiterscheiben sind in einer Kassette gestapelt, die ein deckenmontiertes Transportsystem (overhead hoist transport, OHT) an eine DSP-Poliermaschine zu deren Beladung anliefert. Es können offene oder geschlossene Kassetten, beispielsweise sogenannte FOUPs verwendet werden. Offene Kassetten, also Kassetten ohne Vordertür, sind bevorzugt, wenn die zu polierenden Halbleiterscheiben darin vertikal stehend gestapelt sind. Wegen ihres Aufbaus ermöglicht eine solche offene Kassette den direkten Zugang zu den Halbleiterscheiben, sobald die offene Kassette vom OHT auf einer Kassettenaufnahme des Vertikaltransportsystems abgestellt und vom Vertikaltransportsystem zum Scheibenheber bis zu einer Endposition abgesenkt wurde. In der Endposition stehen die zu polierenden Halbleiterscheiben in Rillen einer Scheibenaufnahme des Scheibenhebers und werden durch Rillen einer Führung des Vertikaltransportsystems seitlich gestützt. Aufgrund dieser Anordnung verfügt das Vertikaltransportsystem über eine inhärent vorhandene Zentrierfunktion, das heißt, die zu polierenden Halbleiterscheiben befinden sich auf dem Scheibenheber stehend in einem zentrierten Zustand. Das bedeutet, dass eine zu polierende Halbleiterscheibe zur Übergabe an den selbstständig fahrenden Roboter bereits so angeboten wird, dass ein Manipulator des selbstständig fahrenden Roboters die Halbleiterscheibe im Zentrum ansaugen kann, ohne zuvor deren Zentrum selbst ermitteln zu müssen oder ohne dass eine Zentrierstation notwendig wäre, in der die Zentrierung der zu polierenden Halbleiterscheibe vor deren Übergabe an den selbstständig fahrenden Roboter vorgenommen werden müsste. Der Verzicht auf eine eigenständige Zentrierstation ist ebenfalls kosten- und platzsparend und beschleunigt den Beladevorgang, da der Manipulator des selbständig fahrenden Roboters nicht in mehreren Schritten erst die Halbleiterscheibe aus der Kassette, dann in die Zentrierstation und anschließend in die Aussparung der Läuferscheibe transportieren muss.

Ungeachtet dessen soll nicht ausgeschlossen sein, dass eine Zentrierstation bereitsteht, beispielsweise ein Zentrierring, in den die zu polierende Halbleiterscheibe vom Scheibenheber des Vertikaltransportsystems abgelegt wird. Das ist insbesondere dann zweckmäßig, wenn zu polierenden Hableiterscheiben vom deckenmontierten Transportsystem in einem FOUP horizontal angeordnet angeliefert werden. Dann wird eine der zu polierenden Halbleiterscheiben vom Scheibenheber des Vertikaltransportsystems dem FOUP entnommen und zunächst in der Zentrierstation abgelegt, bevor sie vom Manipulator des selbstständig fahrenden Roboters in zentriertem Zustand aufgenommen wird.

Der selbstständig fahrende Roboter ist als fahrerloses Fahrzeug (automated guided vehicle, AGV) konzipiert oder auf ein AGV montiert und steuert dessen Bewegungen. Vorzugsweise bewegt sich der selbstständig fahrende Roboter auf Rädern fort. Er umfasst einen Arm, an dessen Ende ein Manipulator für Halbleiterscheiben befestigt ist, sowie ein optisches Erkennungssystem, vorzugsweise eine Kamera. Diese Kamera wird zum Erkennen von Markierungen an Läuferscheiben der Poliermaschinen eingesetzt, vorzugsweise von Markierungen auf der Oberfläche der Läuferscheiben. Aufgrund der Lage der Markierungen errechnet der Roboter die Position des Zentrums einer Aussparung. Weitere Kameras sind zu diesem Zweck nicht vorgesehen. Der Manipulator umfasst vorzugsweise eine Vorrichtung zum Ansaugen einer Halbleiterscheibe an einer von deren beiden Seitenflächen. Der Manipulator übernimmt eine zu polierende Halbleiterscheibe in zentriertem Zustand vom Scheibenheber des Vertikaltransportsystems oder von der Zentrierstation.

Anschließend beginnt der selbstständig fahrende Roboter das Beladen der DSP-Poliermaschine, die sich im Wartezustand für eine Beladung befindet. Der selbstständig fahrende Roboter ermittelt durch die Kamera die Position des Zentrums einer freien Aussparung einer Läuferscheibe der zu beladenden DSP-Poliermaschine und legt die zu polierende Halbleiterscheibe in die freie Aussparung. Der Vorgang vom Herausheben einer zu polierenden Halbleiterscheibe durch den Scheibenheber des Vertikaltransportsystems bis zum Einlegen der zu polierenden Halbleiterscheibe in eine freie Aussparung einer Läuferscheibe der DSP-Poliermaschine durch den Manipulator des selbstständig fahrenden Roboters wiederholt sich solange, bis die DSP-Poliermaschine mit einer vorgesehenen Anzahl von zu polierenden Halbleiterscheiben beladen ist. In der Regel ist der Vorgang abgeschlossen, wenn die zur Aufnahme von Halbleiterscheiben vorhandenen Aussparungen der Läuferscheiben der Poliermaschine mit zu polierenden Halbleiterscheiben belegt sind.

Nach Abschluss der Beladung wird die Politur durch ein Signal des selbstständig fahrenden Roboters in Gang gesetzt, indem der obere Polierteller gegen den unteren Polierteller abgesenkt und geschlossen wird. Während der Politur dieser Halbleiterscheiben belädt der selbstständig fahrende Roboter eine andere der Poliermaschinen mit zu polierenden Halbleiterscheiben oder entlädt polierte Halbleiterscheiben aus einer anderen Poliermaschinen.

Bevorzugt ist insbesondere das Polieren eines Teils der der Einrichtung zur Verfügung gestellten Halbleiterscheiben auf mindestens einer der Poliermaschinen, während der selbstständig fahrende Roboter eine der Halbleiterscheiben eines anderen Teils dieser Halbleiterscheiben vom Scheibenheber des Vertikaltransportsystems oder von der Zentrierstation übernimmt oder in eine der Aussparungen einlegt oder aus einer der Aussparungen entnimmt.

Für den Entladevorgang ist jeder der Poliermaschinen eine x/y-Lineareinheit zugeordnet, die den Transport einer polierten Halbleiterscheibe in mindestens zwei von drei Raumrichtungen ermöglicht. Die x/y-Lineareinheit umfasst einen Scheibengreifer mit Endeffektoren, der die polierten Halbleiterscheiben beschädigungsfrei an den Rändern greift. Die polierten Halbleiterscheiben werden nach Ende der Politur nacheinander vom Manipulator des selbständig fahrenden Roboters aus den Aussparungen der Läuferscheiben gesaugt, dem Scheibengreifer der x/y Lineareinheit übergeben und anschließend in einen Nasstransportbehälter mit integrierter Scheibenaufnahme einsortiert. Zu diesem Zweck hat der Scheibengreifer mit Endeffektoren eine möglichst schmale Bauform, vorzugsweise derart, dass er in einen Schlitz mit nicht mehr als 5 mm Breite passt. Die Scheibenaufnahme des Nasstransportbehälters verfügt über eine Anzahl von Schlitzen, in denen jeweils eine polierte Halbeiterscheibe vertikal positioniert abgelegt werden kann. Nach der Entnahme einer polierten Halbleiterscheibe aus einer Aussparung einer Läuferscheibe durch den Manipulator am Arm des selbstständig fahrenden Roboters übernimmt der Scheibengreifer der x/y-Lineareinheit mit seinen Endeffektoren die polierte Halbleiterscheibe vom selbstständig fahrenden Roboter. Dadurch, dass ab diesem Zeitpunkt die Zuständigkeit für die polierte Halbleiterscheibe dem selbstständig fahrenden Roboter abgenommen wird, dauert der Entladevorgang weniger lang, als wenn dessen Zuständigkeit weiterbestünde.

Anschließend transportiert die x/y-Lineareinheit die polierte Halbleiterscheibe mit Hilfe des Scheibengreifers über den mit Flüssigkeit gefüllten Nasstransportbehälter und schiebt die Halbleiterscheibe von oben in einen freien Schlitz der Scheibenaufnahme des Nasstransportbehälters. Nach der Freigabe der polierten Halbleiterscheibe durch die Endeffektoren und dem Rückzug des Scheibengreifers steht die Halbleiterscheibe vertikal in der Scheibenaufnahme des Nasstransportbehälters und ist umgeben von der Flüssigkeit im Nasstransportbehälter. Zumindest die mit der Flüssigkeit in Kontakt kommende Oberfläche des Nasstransportbehälters besteht vorzugsweise aus einem chemisch beständigen Material, das sowohl gegen basische als auch gegen säurehaltige Medien beständig ist.

Um zu verhindern, dass an den Oberflächen der polierten Halbleiterscheiben chemische Reaktionen oder physikalische Veränderungen stattfinden, werden nach einer Politur vorzugsweise alle polierten Halbleiterscheiben einer DSP-Poliermaschine vom selbstständig fahrenden Roboter entladen, bevor der selbstständig fahrende Roboter eine andere der DSP-Poliermaschinen mit zu polierenden Halbleiterscheiben belädt oder polierte Halbleiterscheiben aus einer anderen DSP-Poliermaschine entlädt.

Das Entladen einer polierten Halbleiterscheibe aus der Aussparung einer Läuferscheibe erfolgt analog zum Beladen einer zu polierenden Halbleiterscheibe. Die polierte Halbleiterscheibe wird mit dem Manipulator am Arm des selbstständig fahrenden Roboters an der polierten oberen Seitenfläche angesaugt und aus der Aussparung gehoben. Zweckmäßigerweise sind im Speicher des Roboters Informationen zu den mit Halbleiterscheiben belegten Aussparungen der Läuferscheiben enthalten, insbesondere die Positionen der Zentren der Halbleiterscheiben.

Der Nasstransportbehälter, der vorzugsweise automatisch mit Flüssigkeit befüllt und entleert werden kann, wird mit den darin enthaltenen polierten Halbleiterscheiben automatisch auf ein AGV umgeladen, beispielsweise mittels Band-, Rollen- oder Linearförderung, und vom AGV autonom und im Raum frei und automatisch navigierend zu einer Reinigungsanlage für polierte Halbeiterscheiben gefahren, wo der Nasstransportbehälter automatisch übergeben und vorzugsweise über einen Adapter angekoppelt wird, der stirnseitig am Nasstransportbehälter angebracht ist. Zum Betreiben dieses AGVs kann auf einen mitfahrenden Roboter verzichtet werden. Vorzugsweise wird mehreren der DSP-Poliermaschinen dasselbe AGV zum Abholen und Bereitstellen der Nasstransportbehälter zugeordnet, beispielsweise ein AGV für bis zu zehn DSP-Poliermaschinen, besonders bevorzugt ein AGV für diejenigen DSP-Poliermaschinen, für die der selbstständig fahrende Roboter zuständig ist.

Die Erfindung wird nachfolgend unter Bezugnahme auf Zeichnungen weiter erklärt.

### Kurzbeschreibung der Figuren

**Fig. 1** zeigt einen Aspekt der Erfindung.
**Fig. 2** zeigt einen anderen Aspekt der Erfindung.
**Fig. 3** zeigt ein Vertikaltransportsystem einer erfindungsgemäßen Einrichtung.
**Fig. 4** zeigt eine x/y-Lineareinheit einer erfindungsgemäßen Einrichtung.

### Liste der verwendeten Bezugszeichen

- **1**: Einrichtung zum Polieren von Halbleiterscheiben
- **2**: DSP-Poliermaschine
- **3**: unterer Polierteller
- **4**: Läuferscheibe
- **5**: Aussparung
- **6**: Halbleiterscheibe
- **7**: selbstständig fahrender Roboter
- **8**: OHT
- **9**: x/y-Lineareinheit
- **10**: Nasstransportbehälter
- **11**: AGV
- **12**: Reinigungsanlage
- **13**: Vertikaltransportsystem
- **14**: Kassettenaufnahme
- **15**: Scheibenheber
- **16**: Führung
- **17**: Scheibengreifer
- **18**: Endeffektor
- **19**: Leiste
- **20**: Zentrierstation

### Detaillierte Beschreibung erfindungsgemäßer Ausführungsbeispiele

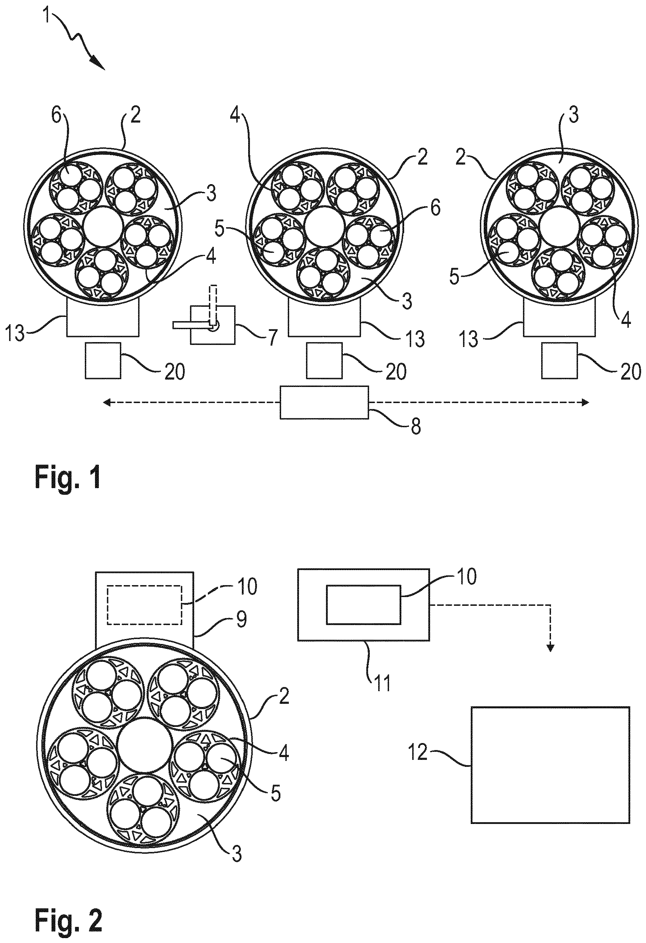

Die in Fig. 1 dargestellte erfindungsgemäße Einrichtung 1 zum Polieren von Halbleiterscheiben, die als Beispiel zu verstehen ist, umfasst drei DSP-Poliermaschinen 2, deren untere Polierteller 3 in Draufsicht gezeichnet sind. Auf den unteren Poliertellern liegen Läuferscheiben 4 mit Aussparungen 5 für Halbleiterscheiben 6. Die links angeordnete DSP-Poliermaschine befindet sich in Betrieb und alle Aussparungen 5 der Läuferscheiben 4 sind mit zu polierenden Halbleiterscheiben 6 belegt. Der geschlossene obere Polierteller dieser DSP-Poliermaschine und die geöffneten oberen Polierteller der beiden anderen DSP-Poliermaschinen sind nicht dargestellt. Die mittlere DSP-Poliermaschine 2 ist teilweise mit zu polierenden Halbleiterscheiben 6 beladen, während sich die rechts angeordnete DSP-Poliermaschine 2 im entladenen Zustand befindet.

Zum Be- und Entladen ist ein einziger, selbstständig fahrender Roboter 7 den DSP-Poliermaschinen 2 zugeordnet. In der Darstellung von Fig.1 ist der selbstständig fahrende Roboter 7 damit beschäftigt, zu polierende Halbleiterscheiben 6 in die noch freien Aussparungen 5 der Läuferscheiben 4 der mittleren DSP-Poliermaschine 2 legen. Zu diesem Zweck übernimmt ein am Arm des Roboters montierter Manipulator eine zu polierende Halbleiterscheibe 6 vom Vertikaltransportsystem 13 oder von der Zentrierstation 20. Zu polierende Halbleiterscheiben werden in einer Kassette, die vorzugsweise offen ausgestaltet ist und die zu polierenden Hableiterscheiben vertikal stehend enthält, durch ein OHT 8 dem Vertikaltransportsystem 13 angeliefert. Der selbstständig fahrende Roboter 7 transportiert die vom Scheibenheber des Vertikaltransportsystems 13 oder von der Zentrierstation 20 übernommene Halbleiterscheibe 6 zur mittleren DSP-Poliermaschine 2 und legt sie in eine der freien Aussparungen 5 von deren Läuferscheiben 4. Der Vorgang wird sich wiederholen, bis die mittlere DSP-Poliermaschine 2 vollständig mit zu polierenden Halbleiterscheiben 6 beladen ist.

Jeder der DSP-Poliermaschinen 2 ist eine x/y-Lineareinheit 9 zugeordnet, die in Fig. 1 nicht dargestellt sind. Fig.2 zeigt die rechts angeordnete DSP-Poliermaschine 2 und die dieser zugeordnete x/y-Lineareinheit 9. Halbleiterscheiben 6, die auf dieser Poliermaschine 2 poliert wurden, wurden vom Manipulator des selbstständig fahrenden Roboters 7 aus den Aussparungen 5 der Läuferscheiben 4 gehoben, von der x/y-Lineareinheit 9 übernommen und in Scheibenaufnahmen eines Nasstransportbehälters 10 abgelegt. Gemäß der Darstellung in Fig.2 wurde der Nasstransportbehälter 10 mit den polierten Halbleiterscheiben 6 von der x/y-Lineareinheit 9 auf ein AGV 11 umgeladen und befindet sich auf dem Transport durch das AGV 11 zu einer Reinigungsanlage 12 für polierte Halbleiterscheiben 6. Zum selben Zeitpunkt ist der selbstständig fahrende Roboter 7 damit beschäftigt, zu polierende Halbleiterscheiben 6 in die noch freien Aussparungen 5 der Läuferscheiben 4 der mittleren DSP-Poliermaschine 2 zu legen.

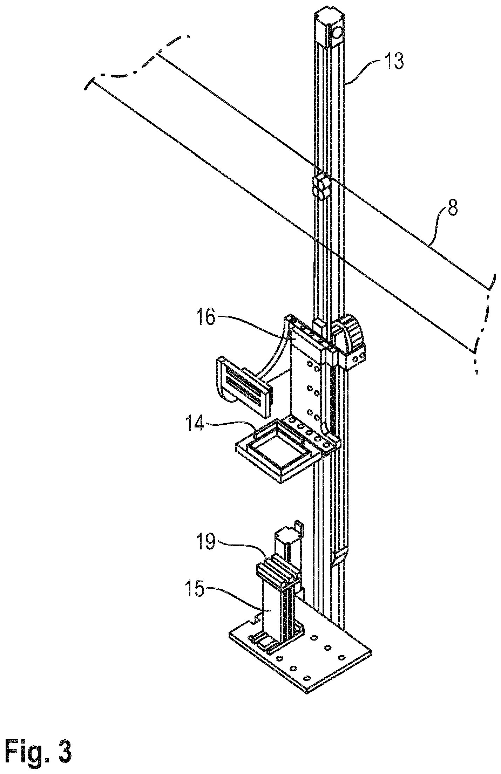

Jeder der DSP-Poliermaschinen ist ein Vertikaltransportsystem 13 zugeordnet, beispielsweise das in Fig. 3 dargestellte bevorzugte Vertikaltransportsystem 13. Dieses Vertikaltransportsystem 13 umfasst eine Kassettenaufnahme 14, auf der eine angelieferte offene Kassette mit zu polierenden Halbleiterscheiben vom OHT 8 abgestellt wird. Die Kassettenaufnahme 14 kann vertikal von einer Höhe im Bereich des OHT bis auf eine Höhe im Bereich des unteren Poliertellers der DSP-Poliermaschine mittels eines Schlittens abgesenkt und angehoben werden. Das Vertikaltransportsystem 13 umfasst des Weiteren einen Scheibenheber 15 mit definierter Lage und Führungen 16 zum seitlichen Abstützen zu polierender Halbleiterscheiben. Beim Absenken einer auf der Kassettenaufnahme 14 abgestellten offene Kassette (nicht dargestellt) auf eine Endposition werden in der offenen Kassette enthaltene zu polierende Halbleiterscheiben vom Scheibenheber 15 aus der offenen Kassette angehoben und stehen danach wegen der definierten Lage des Scheibenhebers 15 in zentriertem Zustand in Rillen von Leisten 19 des Scheibenhebers 15 und seitlich gestützt durch Führungen 16. Die Führungen 16 haben ebenfalls Rillen zur Aufnahme der Kanten der zu polierenden Halbleiterscheiben. In diesem zentrierten Zustand werden die zu polierenden Halbleiterscheiben nacheinander vom Manipulator des selbstständig fahrenden Roboters übernommen, indem sie im Zentrum einer Seitenfläche angesaugt werden. Der Scheibenheber 15 ist vorzugsweise mit mindestens einer Messeinheit ausgestattet, die die Anzahl der angelieferten Halbleiterscheiben feststellt, auf Plausibilität überprüft und diese Informationen an den selbstständig fahrenden Roboter als Steuerungssignal übermittelt. Das Vertikaltransportsystem 13 verfügt auch über eine eigenständig funktionierende Steuerung für die Vertikalbewegung, die ein stufenlos abstimmbares Bewegungsprofil, speziell der Geschwindigkeiten, gewährleistet. Die konstruktive Ausführung des Vertikaltransportsystems ermöglicht auch ein nachträgliches Anbringen des Vertikaltransportsystems 13 an eine DSP-Poliermaschine ohne die Notwendigkeit, umfangreiche Modifikationen der DSP-Poliermaschine vornehmen zu müssen.

Alternativ dazu kann die Kassettenaufnahme ausgestaltet sein, um einen FOUP aufnehmen zu können und der Scheibenheber zusätzlich über einen FOUP-Öffner verfügen.

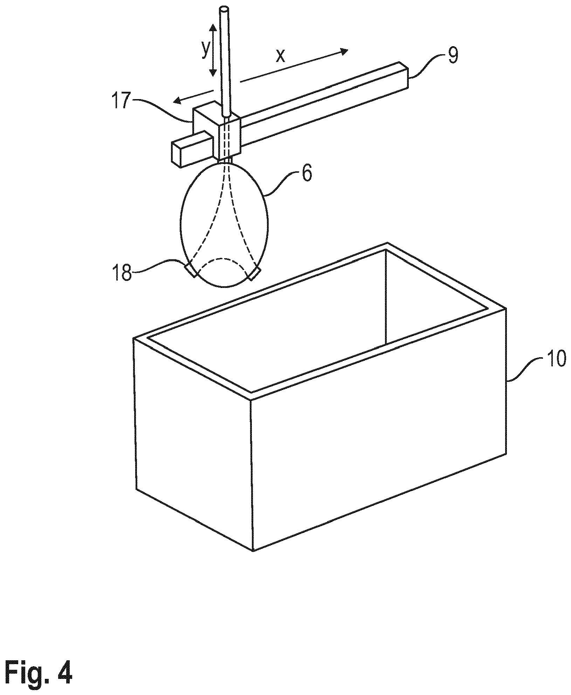

Jeder der DSP-Poliermaschinen ist auch eine x/y-Lineareinheit zugeordnet, beispielsweise die in Fig. 4 dargestellte x/y-Lineareinheit 9. Die x/y-Lineareinheit 9 umfasst einen Scheibengreifer 17 mit Endeffektoren 18 zum Übernehmen einer polierten Halbleiterscheibe vom Manipulator des selbstfahrenden Roboters. Die Endeffektoren 18 fassen die Halbeiterscheibe an deren Kante.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

Derartige Abänderungen und Modifikationen sowie Äquivalente werden durch den Schutzbereich der folgenden Ansprüche definiert.

## Patentansprüche

1. Einrichtung (1) zum Polieren von Halbleiterscheiben, umfassend mindestens zwei Poliermaschinen (2) zum gleichzeitigen beidseitigen Polieren von Halbleiterscheiben;
eine oder mehrere Läuferscheiben (4), die auf einem Poliertuch eines jeweiligen unteren Poliertellers (3) der Poliermaschinen (2) liegen und Aussparungen (5) zur Aufnahme von Halbleiterscheiben (6) aufweisen;
ein deckenmontiertes Transportsystem (8) zum Anliefern einer Kassette, die zu polierende Halbleiterscheiben enthält;
jeder der Poliermaschinen (2) zugeordnet ein Vertikaltransportsystem (13) zum Übernehmen der angelieferten Kassette vom deckenmontierten Transportsystem (8) und aufweisend einen integrierten Scheibenheber (15) zum Herausheben der zu polierenden Halbleiterscheiben aus der Kassette;
einen zu den mindestens zwei Poliermaschinen (2) selbstständig fahrenden Roboter (7) mit einem Manipulator zum Übernehmen der zu polierenden Halbleiterscheibe vom Scheibenheber (15), zum Einlegen der zu polierenden Halbleiterscheibe in eine der Aussparungen (5) und, nach dem Abschluss einer Politur, zum Herausheben der polierten Halbleiterscheibe aus der Aussparung (5);
jeder der Poliermaschinen (2) zugeordnet eine x/y-Lineareinheit (9) mit einem Scheibengreifer (17) zum Übernehmen der polierten Halbleiterscheibe vom Manipulator des selbstständig fahrenden Roboters (7) und zum Ablegen der polierten Halbleiterscheibe in einen Nasstransportbehälter (10) mit integrierter Scheibenaufnahme; und
ein fahrerloses Transportfahrzeug (11) zum Transport des Nasstransportbehälters (10) zu einer Reinigungsanlage (12) für polierte Halbleiterscheiben.

2. Einrichtung nach Anspruch 1, **dadurch gekennzeichnet, dass** die Kassetten offen sind.

3. Einrichtung nach Anspruch 1 oder Anspruch 2, **gekennzeichnet durch** 3 bis 10 Poliermaschinen (2).

4. Einrichtung nach einem der Ansprüche 1 bis 3, **dadurch gekennzeichnet, dass** der Scheibengreifer (17) über Endeffektoren (18) verfügt, die die Halbleiterscheibe an einer Scheibenkante halten und die zwischen Schlitze der Scheibenaufnahme des Nasstransportbehälters (10) tauchen.

5. Verfahren zum Polieren von Halbleiterscheiben, mittels einer Einrichtung nach einem der Ansprüche 1-4 umfassend
das Bereitstellen von mindestens zwei Poliermaschinen (2) zum gleichzeitigen beidseitigen Polieren von Halbleiterscheiben (6);
das Anliefern von zu polierenden Halbleiterscheiben in einer Kassette mittels eines deckenmontierten Transportsystems (8);
das Herausheben einer zu polierenden Halbleiterscheibe aus der Kassette mittels eines Scheibenhebers (15) eines Vertikaltransportsystems (13);
das Übernehmen einer der zu polierenden Halbleiterscheiben vom Scheibenheber (15) des Vertikaltransportsystems (13) oder von einer Zentrierstation (20) durch einen Manipulator eines selbstständig fahrenden Roboters (7);
das Einlegen der zu polierenden Halbleiterscheibe in eine Aussparung (5) einer Läuferscheibe (4) der mindestens zwei Poliermaschinen (2) durch den Manipulator des selbstständig fahrenden Roboters (7);
das Entnehmen einer polierten Halbleiterscheibe aus einer der Aussparungen (5) der Läuferscheiben (4) mittels des Manipulators des selbstständig fahrenden Roboters (7);
das Übernehmen der polierten Halbleiterscheibe vom Manipulator des selbstständig fahrenden Roboters (7) durch einen Scheibengreifer (17) einer x/y-Lineareinheit (9); das Ablegen der polierten Halbleiterscheibe in eine Scheibenaufnahme eines Nasstransportbehälters (10) durch den Scheibengreifer (17);
das Umladen des Nasstransportbehälters (10) von der x/y-Lineareinheit (9) auf ein fahrerloses Transportfahrzeug (11); und
das Transportieren des Nasstransportbehälters (10) mittels des fahrerlosen Transportfahrzeugs (11) zu einer Reinigungsanlage (12) für polierte Halbleiterscheiben.

6. Verfahren nach Anspruch 5, umfassend das Polieren eines Teils der Halbleiterscheiben auf mindestens einer der Poliermaschinen (2), während der selbstständig fahrende Roboter (7) eine der Halbleiterscheiben eines anderen Teils der Halbleiterscheiben übernimmt, in eine der Aussparungen (5) einlegt oder aus einer der Aussparungen (5) entnimmt.

## Claims

1. device (1) for polishing semiconductor wafers, comprising
at least two polishing machines (2) for simultaneous polishing of semiconductor wafers on both sides;
one or more rotor discs (4), which lie on a polishing cloth of a respective lower polishing disc (3) of the polishing machines (2) and have recesses (5) for receiving semiconductor discs (6);
a ceiling-mounted transport system (8) for delivering a cassette containing semiconductor wafers to be polished;
each of the polishing machines (2) is associated with a vertical transport system (13) for taking over the delivered cassette from the ceiling-mounted transport system (8) and comprising an integrated wafer lifter (15) for lifting the semiconductor wafers to be polished out of the cassette;
a robot (7) travelling independently to the at least two polishing machines (2) and having a manipulator for taking over the semiconductor wafer to be polished from the wafer lifter (15), for inserting the semiconductor wafer to be polished into one of the recesses (5) and, after completion of a polish, for lifting the polished semiconductor wafer out of the recess (5);
associated with each of said polishing machines (2), an x/y linear unit (9) having a wafer gripper (17) for picking up the polished wafer from the manipulator of the self-propelled robot (7) and depositing the polished wafer into a wet transport container (10) having an integrated wafer receptacle; and
a driverless transport vehicle (11) for transporting the wet transport container (10) to a cleaning system (12) for polished semiconductor wafers.

2. device according to claim 1, **characterized in that** the cassettes are open.

3. device according to claim 1 or claim 2, **characterized by** 3 to 10 polishing machines (2).

4. device according to any one of claims 1 to 3, **characterized in that** the wafer gripper (17) has end effectors (18) which hold the semiconductor wafer at a wafer edge and which dip between slots of the wafer receptacle of the wet transport container (10).

5. method for polishing semiconductor wafers by means of the device according to any one of claims 1 to 4, comprising
the provision of at least two polishing machines (2) for simultaneous polishing of semiconductor wafers (6) on both sides;
the delivery of semiconductor wafers to be polished in a cassette by means of a ceiling-mounted transport system (8);
lifting a semiconductor wafer to be polished out of the cassette by means of a wafer lifter (15) of a vertical transport system (13);
taking over one of the semiconductor wafers to be polished from the wafer lifter (15) of the vertical transport system (13) or from a centering station (20) by a manipulator of an autonomously moving robot (7);
the insertion of the semiconductor wafer to be polished into a recess (5) of a rotor disc (4) of the at least two polishing machines (2) by the manipulator of the autonomously moving robot (7);
removing a polished semiconductor wafer from one of the recesses (5) of the rotor disks (4) by means of the manipulator of the autonomously moving robot (7);
taking over the polished semiconductor wafer from the manipulator of the autonomously moving robot (7) by a wafer gripper (17) of an x/y linear unit (9); depositing the polished semiconductor wafer into a wafer receptacle of a wet transport container (10) by the wafer gripper (17);
reloading the wet transport container (10) from the x/y linear unit (9) onto a driverless transport vehicle (11); and
transporting the wet transport container (10) by means of the driverless transport vehicle (11) to a cleaning system (12) for polished semiconductor wafers.

6. the method according to claim 5, comprising polishing a part of the semiconductor wafers on at least one of the polishing machines (2) while the autonomously travelling robot (7) takes over one of the semiconductor wafers of another part of the semiconductor wafers, places it in one of the recesses (5) or takes it out of one of the recesses (5).

## Revendications

1. dispositif (1) de polissage de plaquettes semi-conductrices, comprenant au moins deux machines de polissage (2) pour le polissage simultané des deux côtés des plaquettes semi-conductrices ;
un ou plusieurs disques de rotor (4) qui reposent sur un drap de polissage d'un plateau de polissage inférieur respectif (3) des machines de polissage (2) et qui présentent des évidements (5) pour recevoir des disques semi-conducteurs (6) ;
un système de transport (8) monté sur le plafond pour livrer une cassette contenant des plaquettes semi-conductrices à polir ;
chacune des machines de polissage (2) est associée à un système de transport vertical (13) pour prendre en charge la cassette livrée à partir du système de transport (8) monté au plafond et présentant un lève-glace (15) intégré pour soulever les galettes semi-conductrices à polir hors de la cassette ;
un robot (7) se déplaçant de manière autonome vers les au moins deux machines de polissage (2), avec un manipulateur pour prendre en charge la plaquette semi-conductrice à polir du lève-plaquette (15), pour placer la plaquette semi-conductrice à polir dans l'un des évidements (5) et, après la fin d'un polissage, pour retirer la plaquette semi-conductrice polie de l'évidement (5) ;
à chacune des machines de polissage (2) est associée une unité linéaire x/y (9) avec un préhenseur de plaquette (17) pour prendre la plaquette semi-conductrice polie du manipulateur du robot (7) se déplaçant de manière autonome et pour déposer la plaquette semi-conductrice polie dans un récipient de transport humide (10) avec un logement de plaquette intégré ; et
un véhicule de transport sans conducteur (11) pour transporter le conteneur de transport humide (10) vers une installation de nettoyage (12) pour des plaquettes semi-conductrices polies.

2. Dispositif selon la revendication 1, **caractérisé en ce que** les cassettes sont ouvertes.

3. Dispositif selon la revendication 1 ou la revendication 2, **caractérisé par** 3 à 10 machines de polissage (2).

4. dispositif selon l'une des revendications 1 à 3, **caractérisé en ce que** le dispositif de préhension de plaquette (17) dispose d'effecteurs d'extrémité (18) qui maintiennent la plaquette semi-conductrice sur un bord de la plaquette et qui plongent entre des fentes du logement de plaquette du récipient de transport humide (10).

5. procédé de polissage de plaquettes semi-conductrices au moyen d'un dispositif selon l'une des revendications 1 à 4, comprenant
la mise à disposition d'au moins deux machines de polissage (2) pour le polissage simultané des deux côtés de plaquettes semi-conductrices (6) ;
la livraison de plaquettes semi-conductrices à polir dans une cassette au moyen d'un système de transport (8) monté sur le plafond ;
l'extraction d'une plaquette semi-conductrice à polir de la cassette au moyen d'un élévateur de plaquette (15) d'un système de transport vertical (13) ;
la prise en charge d'une des plaquettes semi-conductrices à polir depuis le lève-plaquette (15) du système de transport vertical (13) ou depuis une station de centrage (20) par un manipulateur d'un robot (7) se déplaçant de manière autonome ;
la mise en place de la plaquette semi-conductrice à polir dans un évidement (5) d'un disque de rotor (4) des au moins deux machines de polissage (2) par le manipulateur du robot (7) se déplaçant de manière autonome ;
le prélèvement d'une plaquette semi-conductrice polie dans l'un des évidements (5) des plaquettes de rotor (4) au moyen du manipulateur du robot (7) à déplacement autonome ;
la prise en charge de la plaquette semi-conductrice polie par le manipulateur du robot (7) se déplaçant de manière autonome par un préhenseur de plaquette (17) d'une unité linéaire x/y (9) ;
le dépôt de la plaquette semi-conductrice polie dans un logement de plaquette d'un conteneur de transport humide (10) par le préhenseur de plaquette (17) ;
le transfert du conteneur de transport humide (10) de l'unité linéaire x/y (9) sur un véhicule de transport sans conducteur (11) ; et
le transport du conteneur de transport humide (10) au moyen du véhicule de transport sans conducteur (11) vers une installation de nettoyage (12) pour des plaquettes semi-conductrices polies.

6. Procédé selon la revendication 5, comprenant le polissage d'une partie des plaquettes semi-conductrices sur au moins l'une des machines de polissage (2), tandis que le robot (7) se déplaçant de manière autonome prend en charge l'une des plaquettes semi-conductrices d'une autre partie des plaquettes semi-conductrices, l'insère dans l'un des évidements (5) ou la retire de l'un des évidements (5).
